# EUROPÄISCHE PATENTANMELDUNG

(11) **EP 0 949 652 A1**
(43) Veröffentlichungstag der Anmeldung: **13.10.1999**
(21) Anmeldenummer: 99105288.7
(22) Anmeldetag: 15.03.1999
(51) Int. Cl.: H01J 37/28

(54) **Verfahren zur Erzeugung von Echtzeit-Stereobildern von Werkstoffproben mittels Teilchenstrahl-Rastermikroskopen**

(30) Priorität: 24.03.1998 DE 19812782; 24.12.1998 DE 19860224
(71) Anmelder: Institut für Festkörper- und Werkstofforschung Dresden e.V., 01069 Dresden (DE)
(72) Erfinder: Menzel, Siegfried, Dr., 01069 Dresden (DE); Buerke, Axel, 01099 Dresden (DE); Göbel, Thomas, 01097 Dresden (DE); Wetzig, Klaus, Prof. Dr., 01259 Dresden (DE)
(74) Vertreter: Rauschenbach, Dieter

(57) **Zusammenfassung**

Der Erfindung liegt die Aufgabe zugrunde, ein Verfahren für Teilchenstrahl-Rastermikroskope zu schaffen, das die Erzeugung von Echtzeit-Stereobildern von Werkstoffproben ermöglicht.

Diese Aufgabe wird dadurch gelöst, dass von jedem abgerasterten Scanningpunkt zwei Bildsignale erzeugt werden, indem der Teilchenstrahl des Rastermikroskops an jedem Scanningpunkt um die Winkel +ϕ und -ϕ zur Probennormalen auf der Probe gekippt wird, wobei in beiden Winkelpositionen die Bildsignale erfasst werden, oder indem ein Rastermikroskop mit zwei Teilchenstrahlen verwendet wird, wobei der eine Teilchenstrahl mit dem Winkel +ϕ und der andere mit -ϕ auf die Probe gerichtet wird und dabei jeweils die Bildsignale erfasst werden, und dass die so für jeden Scanningpunkt erhaltenen beiden Bildsignale rechentechnisch zu Abbildungswerten für eine dreidimensionale Abbildung der Scanningpunkte verknüpft werden.

Das Verfahren ermöglicht das Sichtbarmachen, Vergrößern, Abbilden und Aufklären der räumlichen Oberflächenstruktur und ist auch bei anderen bildgebenden Techniken mit Teilchenstrahlen anwendbar, wie beispielsweise beim Sekundärionen-Massenspektrometer und der Focused Ion Beam-Technik.

## Beschreibung

Die Erfindung betrifft ein Verfahren zur Erzeugung von Echtzeit-Stereobildern von Werkstoffproben mittels Teilchenstrahl-Rastermikroskopen. Das Verfahren ermöglicht das Sichtbarmachen, Vergrößern, Abbilden und Aufklären der räumlichen Oberflächenstruktur von Werkstoffproben.

Das Verfahren ist auch bei anderen bildgebenden Techniken mit Teilchenstrahlen anwendbar, wie beispielsweise beim Sekundärionen-Massenspektrometer (SIMS) und der Focused Ion Beam-Technik (FIB).

Bei der Rasterelektronenmikroskopie wird die Probenoberfläche mit einem Primärelektronenstrahl abgerastert und zum Beispiel durch das Signal der ausgelösten Sekundär- oder Rückstreuelektronen auf einem Bildschirm abgebildet. Es handelt sich also um die Projektion der 3-dimensionalen Oberfläche in eine Ebene. Dabei geht die räumliche Information verloren und kann nur über zusätzliche Schritte (Probenkippung, Interpretation des Bildkontrastes) erhalten werden. Eine Online-3D-Betrachtung der Probenoberfläche ist deshalb bisher nicht möglich.

Das menschliche 3D-Sehen beruht auf der Kombination von zwei (zweidimensionalen) Bildern, die von den Augen aufgenommen und im Gehirn zu einem räumlichen Eindruck kombiniert werden. Diese beiden Bilder weisen Positionsverschiebungen von Punkten auf, die sich in verschiedenen Entfernungen vom Betrachter befinden (Parallaxe).

Bei der herkömmlichen Methode zur Erzeugung stereoskopischer Bilder im Rasterelektronenmikroskop wird die Parallaxe durch zwei Probenkippungen um kleine Winkel ±ϕ (ϕ = 5°bis 15°) relativ zum Primärelektronenstrahl erreicht. Dem menschlichen Sehen entsprechend sollte die Kippung symmetrisch sein und muß um eine senkrechte Kippachse erfolgen.

Die beiden in diesen Probenstellungen aufgenommenen REM-Abbildungen der Probenoberfläche entsprechen den Seheindrücken des rechten bzw. linken Auges. Da sich während der Probenkippung der abgebildete Probenbereich verschieben oder verdrehen kann, müssen beide Abbildungen rechnerisch computergestützt korreliert werden. Probenkippung und die aufwendige Bildkorrelation stehen einer Echtzeitdarstellung der Abbildung entgegen.

Zur Rekonstruktion des dreidimensionalen Abbildes der Probe müssen beide Abbildungen einzeln dem jeweiligen Auge zugeordnet werden. Herkömmliche Methoden hierzu sind die Rot-Grün-Darstellung am Monitor oder auf Papier in Verbindung mit einer Farbfilter-Brille, die Projektion mit polarisiertem Licht in Verbindung mit einer Polarisationsfilter-Brille oder Verwendung von getrennten Monitoren für jedes Auge ('cyber space')

Der Erfindung liegt die Aufgabe zugrunde, ein Verfahren für Teilchenstrahl-Rastermikroskope zu schaffen, das die Erzeugung von Echtzeit-Stereobildern von Werkstoffproben ermöglicht.

Diese Aufgabe wird nach der Erfindung dadurch gelöst, dass im Teilchenstrahl-Rastermikroskop von jedem abgerasterten Scanningpunkt zwei Bildsignale erzeugt werden, indem der Teilchenstrahl des Rastermikroskops an jedem abgerasterten Scanningpunkt um die Winkel +ϕ und -ϕ zur Probennormalen auf der Probe gekippt wird, wobei in jeder der beiden Winkelpositionen die Bildsignale des Scanningpunktes erfasst werden, oder indem ein Rastermikroskop mit zwei Teilchenstrahlen verwendet wird, wobei der eine Teilchenstrahl mit dem Winkel +ϕ und der andere Teilchenstrahl mit dem Winkel -ϕ auf die Probe gerichtet wird und dabei jeweils die Bildsignale des Scanningpunktes erfasst werden, und dass die so für jeden Scanningpunkt erhaltenen beiden Bildsignale rechentechnisch zu Abbildungswerten für eine dreidimensionale Abbildung der Scanningpunkte verknüpft werden.

Diese erfindungsgemäße Kippung beziehungsweise Zweistrahlanwendung sind mit hoher Geschwindigkeit, quasi verzögerungsfrei zum Bildaufbau realisierbar. Um jeden der Winkel +ϕ und -ϕ wird eine rasterelektronische Abbildung ein und desselben Probenbereiches erzeugt und über die oben genannten Verfahren jeweils einem Auge zugeordnet.

Die Probenabbildung kann durch verschiedene Signale unterschiedlicher Detektoren erfolgen. Entscheidende Voraussetzung für eine Stereoabbildung ist, dass die Bildsignale Topographieinformationen beinhalten.

Mit dem Verfahren entfällt die zeitaufwendige Probenkippung und somit die Bildkorrelation mittels Computer. Da der Elektronenstrahl sehr genau positioniert werden kann, ist eine Bildkorrelation der beiden Abbildungen automatisch gegeben.

Im Gegensatz zum SACP-(**S**elected **A**rea **C**hanneling **P**attern)-Verfahren, bei dem der Primärstrahl nur an ein und demselben Punkt der Probenoberfläche kontinuierlich hin- und hergeschwenkt wird, ist eine kontinuierliche Einstellung des Strahl-Kippwinkels nicht zwingend notwendig.

Anstelle der beim SACP erforderlichen großen Austrittsblende kann erfindungsgemäß der Teilchenstrahl beziehungsweise können die beiden Teilchenstrahlen durch eine über der Probe verwendete Aperturblende mit zwei kleinen Blendenöffnungen auf die Probe gerichtet werden, wobei der Abstand zwischen den Blendenöffnungen sowie der Abstand zwischen Blende und Probe entsprechend der vorgesehenen Winkel +ϕ/-ϕ und dem Arbeitsabstand zwischen Teilchenstrahlquelle und Probe zu wählen ist.

Damit kann über die Verringerung des Fokusdurchmessers eine Verkleinerung der Apertur, verbunden mit einer Verbesserung der Abbildungsqualität, erreicht werden. Durchmesser und gegenseitiger Abstand der Blendenöffnungen der DoppelAperturblende werden austauschbar gehalten.

Wichtig dabei ist, dass sowohl eine Strahlführung durch Strahlkippung als auch eine Rasterung des Primärelektronenstrahles durch jede der beiden Blendenbohrungen auf der Probenoberfläche realisierbar ist.

Wichtig ist außerdem, dass der durch die Rasterung zusätzlich verursachte Auslenkwinkel des Primärstrahles klein gegenüber der eingestellten Strahlkippung ist, um einen ausreichenden Steroeindruck zu erzielen.

Gemäß einer zweckmäßigen Ausgestaltung der Erfindung wird im Falle der Kippung des Teilchenstrahls die Abrasterung der Probenoberfläche punktweise durchgeführt.

Nach der Erfindung kann im Falle der Kippung des Teilchenstrahls die Abrasterung der Probenoberfläche jedoch auch zeilenweise durchgeführt werden, indem jede Zeile einmal im Vorwärtsgang und einmal im Rückwärtsgang abgetastet wird, wobei im Vorwärtsgang der Teilchenstrahl mit dem einen Winkel (+ϕ) und im Rückwartsgang mit dem anderen Winkel (-ϕ) auf die Probe gerichtet wird.

Nach einer weiteren zweckmäßigen Ausgestaltung der Erfindung kann im Falle der Kippung des Teilchenstrahls die Abrasterung der Probenoberfläche auch bildweise durchgeführt werden, indem zunächst ein erstes Teilbild und anschließend ein zweites Teilbild erzeugt wird, wobei der Teilchenstrahl für das erste Teilbild mit dem einen Winkel (+ϕ) und für das zweite Teilbild mit dem anderen Winkel (-ϕ) gekippt über die Probe geführt wird.

Die erhaltenen Bildsignale werden erfindungsgemäß zur Herstellung von Topographie- und Materialkontrastbildern verwendet, indem die Bildsignale gleicher Probenorte bei um +ϕ bzw. -ϕ gekipptem Primärstrahl mittels Addition oder Subtraktion überlagert werden.

Gemäß einer bevorzugten Ausgestaltung des Verfahrens werden die erhaltenen Bildsignale einem autostereoskopischen Monitor zugeführt, der die dreidimensionale Darstellung von Bildern ohne Betrachterbrille und die Betrachtung bei variablen Betrachterpositionen ermöglicht.

Erfindungsgemäß können die erhaltenen Bildsignale auch rechentechnisch für eine quantitative Bildanalyse ausgewertet werden, insbesondere zur Bestimmung von Längen, Volumina und Winkeln in Mikrobereichen der Probe.

Nachstehend ist die Erfindung an Hand von Ausführungsbeispielen näher erläutert. In der zugehörigen Zeichnung zeigen:
- Fig. 1:: eine Prinzipdarstellung zur erfindungsgemäßen Verfahrensweise,
- Fig. 2:: ein Verfahrensschema betreffend den Fall einer punktweisen Abrasterung der Probe,
- Fig. 3:: ein Verfahrensschema betreffend den Fall einer zeilenweisen Abrasterung der Probe,
- Fig. 4:: ein Verfahrensschema betreffend den Fall einer bildweisen Erfassung der Probe.

### Beispiel 1

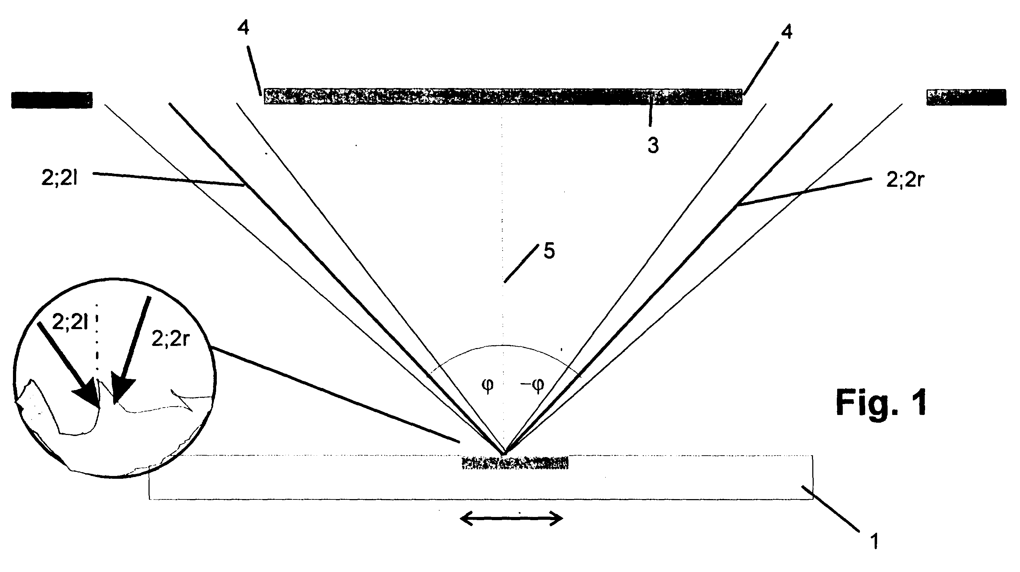

Bei der in Fig.1 ersichtlichen Verfahrensweise wird in einem Teilchenstrahl-Rastermikroskop eine Probe 1 mit einem Teilchenstrahl 2 abgerastert. Über der Probe befindet sich im Abstand eine Aperturblende 3 mit zwei Blendenöffnungen 4, durch die der Teilchenstrahl 2 hindurchtritt.

Von jedem abgerasterten Scanningpunkt werden zwei Bildsignale erzeugt, indem der Teilchenstrahl 2 des Rastermikroskops an jedem abgerasterten Scanningpunkt in den Winkeln +ϕ und -ϕ zur Probennormalen 5 auf die Probe 1 gerichtet wird. In jeder der beiden Winkelpositionen werden die Bildsignale des jeweiligen Scanningpunktes erfasst.

Die Durchführung des Verfahrens ist dabei mit einem Einstrahl-oder einem Zweistrahl-Rastermikroskop möglich. Im erstgenannten Fall wird der Teilchenstrahl 2 um die Winkel +ϕ und -ϕ zur Probennormalen auf der Probe 1 gekippt. Im zweiten Fall wird der linke Teilchenstrahl 2 l mit dem Winkel +ϕ und der rechte Teilchenstrahl 2 r mit dem Winkel -ϕ auf den jeweiligen Scanningpunkt der Probe gerichtet.

Für jeden Scanningpunkt werden auf diese Weise in beiden Fällen zwei Bildsignale erhalten (siehe Einzelheitdarstellung in der linken Hälfte von Fig. 1). Die so jeweils erhaltenen beiden Bildsignale werden rechentechnisch zu Abbildungswerten für eine dreidimensionale Abbildung der Scanningpunkte verknüpft.

Die verknüpften Abbildungswerte werden einem autostereoskopischen Monitor zugeführt, der die dreidimensionale Darstellung von Bildern ohne Betrachterbrille und die Betrachtung bei variablen Betrachterpositionen ermöglicht.

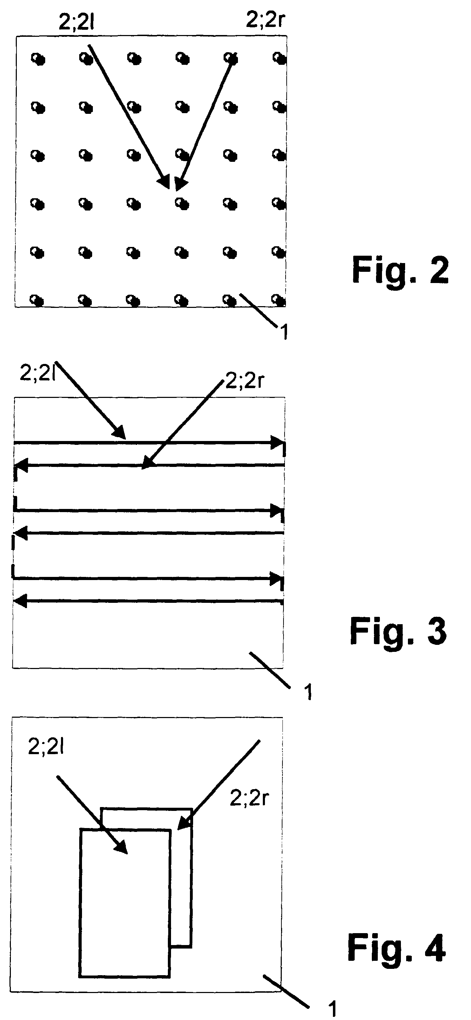

Die Erzeugung der beiden Bilder erfolgt vorzugsweise Punkt für Punkt, wie dies in Fig. 2 gezeigt ist, indem die im Winkel +ϕ erfaßte Information der ersten Abbildung zugeordnet und die beim Strahlkippwinkel -ϕ erfaßte Information desselben Scanningpunktes der zweiten Abbildung zugewiesen wird.

### Beispiel 2

Dieses Beispiel betrifft die Möglichkeit einer zeilenweisen Erfassung der Bildsignale der Scanningpunkte (Fig. 3). Dabei wird die im Winkel +ϕ in positiver x-Richtung erfaßte Zeileninformation der 1. Abbildung und die im Winkel -ϕ in negativer x-Richtung erfaßte Information derselben Zeile zugeordnet. Anschließend erfolgt bei der Position x = 0 der Übergang zur nächsten Zeile.

### Beispiel 3

Dieses Beispiel betrifft eine weitere Möglichkeit der Erfassung der Bildsignale, nämlich die bildweise Erfassung der Probe (Fig. 4) . Hierbei wird zuerst das gesamte Rasterbild mit dem um +ϕ gekippten Primärstrahl und danach das zweite Rasterbild mit dem um -ϕ gekippten Primärstrahl erzeugt.

## Patentansprüche

1. Verfahren zur Erzeugung von Echtzeit-Stereobildern von Werkstoffproben mittels Teilchenstrahl-Rastermikroskopen, **dadurch gekennzeichnet,** dass von jedem abgerasterten Scanningpunkt zwei Bildsignale erzeugt werden, indem der Teilchenstrahl des Rastermikroskops an jedem abgerasterten Scanningpunkt um die Winkel +ϕ und -ϕ zur Probennormalen auf der Probe gekippt wird, wobei in jeder der beiden Winkelpositionen die Bildsignale des Scanningpunktes erfasst werden, oder indem ein Rastermikroskop mit zwei Teilchenstrahlen verwendet wird, wobei der eine Teilchenstrahl mit dem Winkel +ϕ und der andere Teilchenstrahl mit dem Winkel -ϕ auf die Probe gerichtet wird und dabei jeweils die Bildsignale des Scanningpunktes erfasst werden, und dass die so für jeden Scanningpunkt erhaltenen beiden Bildsignale rechentechnisch zu Abbildungswerten für eine dreidimensionale Abbildung der Scanningpunkte verknüpft werden.

2. Verfahren nach Anspruch 1, **dadurch gekennzeichnet,** dass der beziehungsweise die Teilchenstrahlen durch eine über der Probe verwendete Aperturblende mit zwei Blendenöffnungen auf die Probe gerichtet wird, wobei der Abstand zwischen den Blendenbohrungen sowie der Abstand zwischen Blende und Probe entsprechend der vorgesehen Winkel +ϕ und -ϕ und der Arbeitsabstand zwischen Teilchenstrahlquelle und Probe gewählt wird.

3. Verfahren nach Anspruch 1, **dadurch gekennzeichnet,** dass im Falle der Kippung des Teilchenstrahls die Abrasterung der Probenoberfläche punktweise durchgeführt wird.

4. Verfahren nach Anspruch 1, **dadurch gekennzeichnet,** dass im Falle der Kippung des Teilchenstrahls die Abrasterung der Probenoberfläche zeilenweise durchgeführt wird, indem jede Zeile einmal im Vorwärtsgang und einmal im Rückwärtsgang abgetastet wird, wobei im Vorwärtsgang der Teilchenstrahl mit dem einen Winkel (+ϕ) und im Rückwärtsgang mit dem anderen Winkel (-ϕ) auf die Probe gerichtet wird.

5. Verfahren nach Anspruch 1, **dadurch gekennzeichnet,** dass im Falle der Kippung des Teilchenstrahls die Abrasterung der Probenoberfläche bildweise durchgeführt wird, indem zunächst ein erstes Teilbild und anschließend ein zweites Teilbild erzeugt wird, wobei der Teilchenstrahl für das erste Teilbild mit dem einen Winkel (+ϕ) und für das zweite Teilbild mit dem anderen Winkel (-ϕ) gekippt über die Probe geführt wird.

6. Verfahren nach Anspruch 1, **dadurch gekennzeichnet,** dass die erhaltenen Bildsignale zur Herstellung von Topographie- und Materialkontrastbildern verwendet werden, indem die Bildsignale gleicher Probenorte bei um +ϕ bzw. -ϕ gekipptem Primärstrahl mittels Addition oder Subtraktion überlagert werden.

7. Verfahren nach Anspruch 1, **dadurch gekennzeichnet,** dass die erhaltenen Bildsignale einem autostereoskopischen Monitor zugeführt werden, der die dreidimensionale Darstellung von Bildern ohne Betrachterbrille und die Betrachtung bei variablen Betrachterpositionen ermöglicht.

8. Verfahren nach Anspruch 1, **dadurch gekennzeichnet,** dass die erhaltenen Bildsignale rechentechnisch für eine quantitative Bildanalyse ausgewertet werden, insbesondere zur Bestimmung von Längen, Volumina und Winkeln in Mikrobereichen der Probe.
